# EUROPEAN PATENT APPLICATION

(11) **EP 4 811 427 A1**
(43) Date of publication of application: **23.09.2026**
(21) Application number: 25758061.3
(22) Date of filing: 06.02.2025
(51) Int. Cl.: H01L 23/15, C04B 37/02, H01L 23/13, H05K 1/03

(54) **CERAMIC CIRCUIT BOARD AND SEMICONDUCTOR DEVICE USING SAME**

(30) Priority: 22.02.2024 JP 2024025585
(71) Applicant: Niterra Materials Co., Ltd., Kanagawa 235-0032 (JP)
(72) Inventor: YAMAGATA, Yoshihito, Yokohama-shi, Kanagawa 235-0032 (JP); AOKI, Katsuyuki, Yokohama-shi, Kanagawa 235-0032 (JP)
(74) Representative: Hoffmann Eitle
(86) International application number: PCT/JP2025/003878
(87) International publication number: WO 2025/177849

(57) **Abstract**

There is provided a ceramic circuit board having improved long-term reliability. A ceramic circuit board according to an embodiment includes a ceramic substrate, and a metal portion bonded to the ceramic substrate. In a case where an AC voltage of 50 Hz or 60 Hz is applied between a front face and a back face of the ceramic circuit board at a boosting rate of 200 V/s to measure an arc discharge voltage A (kV) when an arc discharge is detected and to measure a dielectric breakdown voltage B (kV) between the front face and the back face in accordance with IEC 672-2, a ratio A/B is 0.10 or more. Preferably, the ratio A/B is within a range of not less than 0.10 and not more than 0.50. Preferably, the metal portion is bonded to the ceramic substrate with a bonding layer interposed therebetween, and a total area ratio of voids in any cross section of the bonding layer is within a range of not less than 0% and not more than 1%. Preferably, the metal portion is a metal plate having a thickness of 0.2 mm or more, and an upper end portion of at least a part of a side face of the metal plate has an R-shape.

## Description

### [Technical Field]

Embodiments described herein relate generally to a ceramic circuit board and a semiconductor device using the same.

### [Background Art]

A ceramic circuit board on which a semiconductor element is mounted is used as a semiconductor device. With the recent improved performance of semiconductor elements, the operation guarantee temperature has been increasing. Therefore, thermal cycle test characteristics (TCT characteristics) required for ceramic circuit boards have also been increasing.

For example, Japanese Patent No. 6906662 (Patent Literature 1) discloses a ceramic circuit board in which the size and hardness of the bonding layer protruding portion are controlled. Japanese Patent No. 7010950 (Patent Literature 2) discloses a ceramic circuit board that includes a bonding layer having a void ratio of 1% or less. Japanese Patent No. 7332588 (Patent Literature 3) discloses a ceramic circuit board in which the shape of the copper plate side face is controlled. The ceramic circuit boards according to Patent Literature 1 to Patent Literature 3 have had excellent TCT characteristics.

### [Prior Art Documents]

### [Patent Literature]

[Patent Literature 1] Japanese Patent No. 6906662
[Patent Literature 2] Japanese Patent No. 7010950
[Patent Literature 3] Japanese Patent No. 7332588
[Patent Literature 4] Japanese Patent No. 6293772

### [Summary of Invention]

### [Problem to be Solved by the Invention]

Japanese Patent No. 6293772 (Patent Literature 4) discloses a silicon nitride substrate having a dielectric strength of 20 kV/mm or more. A silicon nitride circuit board using a silicon nitride substrate having a high dielectric strength has a high dielectric strength.

When a semiconductor element is mounted on a ceramic circuit board, a semiconductor device is obtained. Some ceramic circuit boards have had insufficient long-term reliability regardless of their high dielectric strength. An investigation of the cause has revealed that a test condition significantly deviating from a practical electric field has been used in the dielectric strength test, and therefore, the dielectric strength has not been an optimum index of the long-term reliability. For example, the practical voltage of semiconductor devices is about 1 kV. Meanwhile, in the test, a large voltage of about 9 kV is applied to measure the dielectric breakdown voltage.

Embodiments have been made to address such a problem, and provide a ceramic circuit board attaining improved long-term reliability for the insulation, and a semiconductor device using the ceramic circuit board.

### [Means for Solving the Problem]

A ceramic circuit board according to an embodiment includes a ceramic substrate, and a metal portion bonded to the ceramic substrate. In a case where an AC voltage of 50 Hz or 60 Hz is applied between a front face and a back face of the ceramic circuit board at a boosting rate of 200 V/s to measure an arc discharge voltage A (kV) when an arc discharge is detected and to measure a dielectric breakdown voltage B (kV) between the front face and the back face in accordance with IEC 672-2, a ratio A/B is 0.10 or more.

### [Brief Description of Drawings]

[FIG. 1] FIG. 1 is a diagram showing an example of a ceramic circuit board according to an embodiment.
[FIG. 2] FIG. 2 is a diagram showing another example of the ceramic circuit board according to the embodiment.
[FIG. 3] FIG. 3 is a diagram showing an example cross-sectional composition of a ceramic substrate.
[FIG. 4] FIG. 4 is a diagram showing an example of a semiconductor device according to the embodiment.

### [Description of Embodiments]

A ceramic circuit board according to an embodiment includes a ceramic substrate, and a metal portion bonded to the ceramic substrate. In a case where an AC voltage of 50 Hz or 60 Hz is applied between a front face and a back face of the ceramic circuit board at a boosting rate of 200 V/s to measure an arc discharge voltage A (kV) when an arc discharge is detected and to measure a dielectric breakdown voltage B (kV) between the front face and the back face in accordance with IEC 672-2, a ratio A/B is 0.10 or more.

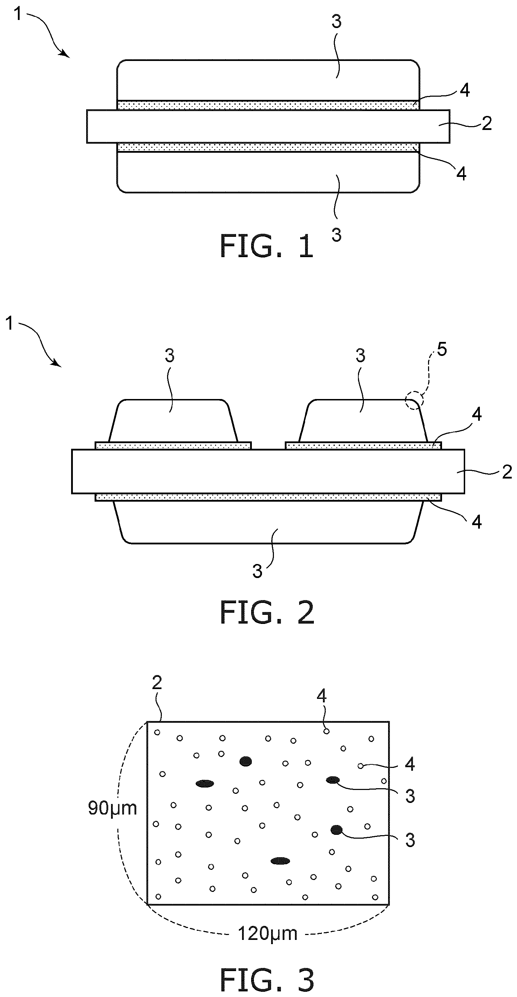

FIG. 1 and FIG. 2 are side views of examples of a ceramic circuit board according to an embodiment. In FIG. 1 and FIG. 2, reference numeral 1 denotes a ceramic circuit board, reference numeral 2 denotes a ceramic substrate, reference numeral 3 denotes a metal portion (metal plate), reference numeral 4 denotes a bonding layer, and reference numeral 5 denotes an upper end portion of the side face of the metal plate.

The shape of the ceramic substrate 2 in plan view may be any of various shapes, such as a rectangular shape, a square shape, a round shape, an elliptic shape, a triangular shape, or a pentagonal shape. In the ceramic substrate 2, holes for screwing may be provided as needed. The ceramic substrate 2 is, for example, a silicon nitride substrate, an aluminum nitride substrate, an aluminum oxide substrate, or a zirconium oxide substrate. The thermal conductivity of silicon nitride substrates is 40 W/m·K or more, and can be 80 W/m·K or more. The three-point bending strength of silicon nitride substrates is 600 MPa or more, and can be 700 MPa or more.

The thermal conductivity of aluminum nitride substrates is 160 W/m·K or more, and can be 200 W/m·K or more. The three-point bending strength of aluminum nitride substrates is about 300 MPa to 450 MPa. Although the three-point bending strength of aluminum oxide substrates is about 300 MPa to 450 MPa, aluminum oxide substrates are less expensive than the other substrates. The thermal conductivity of aluminum oxide substrates is about 20 W/m·K to 30 W/m·K. The three-point bending strength of zirconium oxide substrates is about 550 MPa and high, and the thermal conductivity thereof is about 30 W/m·K to 50 W/m·K.

The metal portion 3 is, for example, a metal plate, a metallized layer, or a thin film. In the examples shown in FIG. 1 and FIG. 2, the metal portion 3 is a metal plate, and the metal portion 3 is bonded to the ceramic substrate 2 with the bonding layer 4 interposed therebetween.

The metal plate is, for example, a copper plate, a copper alloy plate, an aluminum plate, or an aluminum alloy plate. In a case where the ceramic circuit board 1 is provided with a plurality of metal portions 3, only one type selected from among copper plates, copper alloy plates, aluminum plates, and aluminum alloy plates may be used. Alternatively, some of the metal portions 3 may be any one selected from among copper plates, copper alloy plates, aluminum plates, and aluminum alloy plates, and the rest of the metal portions 3 may be another one selected from among copper plates, copper alloy plates, aluminum plates, and aluminum alloy plates.

The metal plate is preferably a copper plate. As the copper plate, an oxygen-free copper plate is preferably used. Oxygen-free copper has a copper purity of 99.96 wt% or more as indicated in JIS-H-3100 (2018). JIS-H-3100 corresponds to, for example, ISO 197.

The thermal conductivity of copper is about 400 W/m·K, and the thermal conductivity of aluminum is about 240 W/m·K. Copper has a higher thermal conductivity than aluminum. Therefore, using a copper plate as the metal plate improves heat dissipation.

In a case where an aluminum plate is used, it is preferable that the aluminum plate be substantially made of pure aluminum. Pure aluminum is specified in JIS-H-4000 (2022). JIS-H-4000 corresponds to ISO 6361.

The thickness of the metal plate is preferably 0.2 mm or more, and more preferably 0.3 mm or more. When the metal plate is made thicker, heat dissipation can be improved. The current carrying capacity of the metal portion 3 can also be improved. Therefore, the thickness of the metal plate is preferably 0.3 mm or more, and more preferably 0.6 mm or more. The upper limit of the thickness of the metal plate is not specifically limited, but is preferably 5 mm or less. If the thickness exceeds 5 mm, control of the inclined shape of the side face of the metal plate may become difficult.

From the viewpoint of heat dissipation, the metal portion 3 is preferably a copper plate having a thickness of 0.6 mm or more. More preferably, a copper plate having a thickness of 0.6 mm or more is provided on each of the front face and the back face of the ceramic substrate 2.

The ceramic substrate 2 and the metal portion 3 are preferably bonded together with the bonding layer 4 interposed therebetween. The bonding layer 4 is preferably formed by using an active metal bonding method. In the active metal bonding method, an active metal brazing filler is used to perform bonding. The main component of the active metal brazing filler is copper (Cu) or silver (Ag). The active metal brazing filler includes one or more types of active metals selected from among Ti (titanium), Zr (zirconium), and Hf (hafnium). The "main component" is a component whose content is largest among the metal components of the brazing filler.

The active metal brazing filler preferably contains Ag (silver) in an amount of not less than 0 mass% and not more than 60 mass%, Cu (copper) in an amount of not less than 15 mass% and not more than 70 mass%, and Ti (titanium) or TiH₂ (titanium hydride) in an amount of not less than 1 mass% and not more than 15 mass%. In a case where both Ti and TiH₂ are used, the total amount of Ti and TiH₂ is within a range of not less than 1 mass% and not more than 15 mass%. In a case where both Ag and Cu are used, Ag is preferably within a range of not less than 20 mass% and not more than 60 mass%, and Cu is preferably within a range of not less than 15 mass% and not more than 40 mass%. One or two types of Sn (tin) and In (indium) may be contained in an amount of not less than 1 mass% and not more than 50 mass% as needed. C (carbon) may be contained in an amount of not less than 0.1 mass% and not more than 2 mass% as needed.

The composition of each component in the active metal brazing filler is calculated by taking the total of mixed raw materials as 100 mass%. For example, in a case where the active metal brazing filler is composed of three types of Ag, Cu, and Ti, the total of Ag, Cu, and Ti is taken as 100 mass%. In a case where the active metal brazing filler is composed of four types of Ag, Cu, TiH₂, and In, the total of Ag, Cu, TiH₂, and In is taken as 100 mass%. In a case where the active metal brazing filler is composed of five types of Ag, Cu, Ti, Sn, and C, the total of Ag, Cu, Ti, Sn, and C is taken as 100 mass%.

Ag or Cu is a component that serves as a base material of the brazing filler. Sn or In has the effect of lowering the melting point of the brazing filler. Adding C (carbon) facilitates control of the fluidity of the brazing filler or facilitates control of the composition of the bonding layer by reacting with other components. Therefore, the components of the brazing filler are preferably, for example, Ag-Cu-Ti, Ag-Cu-Sn-Ti, Ag-Cu-Ti-C, Ag-Cu-Sn-Ti-C, Ag-Ti, Cu-Ti, Ag-Sn-Ti, Cu-Sn-Ti, Ag-Ti-C, Cu-Ti-C, Ag-Sn-Ti-C, or Cu-Sn-Ti-C. In may be used instead of Sn. Both Sn and In may be used. One or more types selected from among tungsten (W), molybdenum (Mo), and rhenium (Re) may be added to the active metal brazing filler within a range of not less than 0.1 mass% and not more than 10 mass%. Adding tungsten, molybdenum, or rhenium facilitates control of the fluidity of the active metal brazing filler. Magnesium (Mg) may be added to the active metal brazing filler. Magnesium may be added within a range of not less than 0.1 mass% and not more than 10 mass%.

In a case where the metal portion 3 is an aluminum plate, as the active metal brazing filler, an Al-Si or Al-Mg brazing filler is preferably used. The contents of one or two types of Si and Mg included in the active metal brazing filler are preferably within a range of not less than 0.1 mass% and not more than 20 mass%.

The ceramic circuit board 1 preferably has a shape such that the bonding layer 4 protrudes from the side face of the metal portion 3. The protruding portion of the bonding layer 4 is also referred to as a bonding layer protruding portion. Providing the bonding layer protruding portion can improve the TCT characteristics of the ceramic copper circuit board.

The metal portion 3 may be a thin film or a metallized layer. The thin film is a conductive film formed by sputtering or plating. The metallized layer is a conductive layer formed by applying a metal powder paste onto the ceramic substrate 2 and firing the paste.

The metal portion 3 may be provided on each face of the ceramic substrate 2. The metal portion 3 (first metal portion) on the front face can be used as a member on which a semiconductor element is mounted. The metal portion 3 (second metal portion) on the back face can be used as a heat dissipation portion. Alternatively, the metal portion 3 on each face may be used as a member on which a semiconductor element is mounted.

On the front face of the ceramic substrate 2, one metal portion 3 may be provided as shown in FIG. 1. A plurality of metal portions 3 may be provided as shown in FIG. 2, or three or more metal portions 3 may be provided. In a case where a plurality of metal portions 3 are provided, each metal portion 3 can be used as a member on which a semiconductor element is mounted. In a case where a semiconductor element is also mounted on the metal portion 3 on the back face, a plurality of metal portions 3 may be provided on the back face.

In the embodiment, in a case where the arc discharge voltage A (kV) of the ceramic circuit board 1 is measured and the dielectric breakdown voltage B (kV) thereof is measured, the ratio A/B is 0.10 or more.

A measurement method for the arc discharge voltage and a measurement method for the dielectric breakdown voltage will now be described.

First, the measurement method for the arc discharge voltage will be described. A pair of electrodes are disposed on the metal portion 3 on the front face and the metal portion 3 on the back face of the ceramic circuit board 1, respectively, and the ceramic circuit board 1 is sandwiched between the pair of electrodes. The pair of electrodes are disposed so as to face each other in a direction perpendicular to the front face of the ceramic substrate 2. In a case where the metal portion 3 is provided only on the front face of the ceramic substrate 2, one of the electrodes is disposed on the metal portion 3 on the front face, and the other electrode is disposed on the back face of the ceramic substrate 2. In a case where a plurality of metal portions 3 are provided on one of the faces of the ceramic substrate 2, the electrode is disposed on any one of the metal portions 3. In this state, an AC voltage of 50 Hz or 60 Hz is applied between the electrodes. The initial value of the voltage is set to 0 V, and the voltage is increased at a boosting rate of 200 V/s. A voltage when an arc discharge is detected between the electrodes is measured as the arc discharge voltage (kV). Once the arc discharge voltage is measured, the application of the voltage is stopped without further increasing the voltage.

For example, as the electrodes, spherical electrodes having a tip diameter of 10 mm specified in JIS-C-2110-1 (2013) are used. JIS-C-2110-1 corresponds to IEC 60243-1. In the measurement environment, the temperature is set at 10°C to 25°C and the humidity is set at 30% to 60%, and the measurement is performed in the atmosphere.

The arc discharge voltage is measured at any three locations in one ceramic circuit board, and the average value is recorded as the arc discharge voltage A (kV). Any three locations are selected so as not to overlap each other. For example, in a case where three or more metal portions 3 are provided on the front face of the ceramic substrate 2, three metal portions 3 are selected in descending order of area. The electrode is disposed on the selected three metal portions 3 one by one to measure the arc discharge voltages. In a case where one metal portion 3 is provided on the front face of the metal portion 3, the arc discharge voltage is measured while the position at which the electrode is disposed is changed in the same metal portion 3. In a case where two metal portions 3 are provided on the front face of the metal portion 3, the arc discharge voltage is measured twice while the position at which the electrode is disposed is changed in one of the metal portions 3, and the arc discharge voltage is measured once in the other metal portion 3.

The maximum voltage to be applied when the arc discharge voltage is measured is 20 kV. The ceramic circuit board 1 is housed in a container and controlled so that the measurement is not affected by the air flow. As the measuring device, it is preferable to use the AC withstand voltage tester-7473 from Keisoku Giken Co., Ltd. Alternatively, a device having an arc discharge detection function equivalent to or higher than that of the AC withstand voltage tester-7473 may be used. As the unit of the arc discharge voltage, "kV/mm" obtained by dividing the voltage by the thickness of the ceramic substrate can be used.

The dielectric breakdown voltage is measured in accordance with the dielectric breakdown strength test of JIS-C-2141 (1992). JIS-C-2141 corresponds to IEC 672-2. The test is conducted by the two-terminal method. A pair of electrodes are disposed on the metal portion 3 on the front face and the metal portion 3 on the back face of the ceramic circuit board 1, respectively, and the ceramic circuit board 1 is sandwiched between the pair of electrodes. In this state, an AC voltage of 50 Hz or 60 Hz is applied between the electrodes. The initial value of the voltage is set to 0 V, and the voltage is increased at a boosting rate of 200 V/s. A voltage at the time of dielectric breakdown of the ceramic circuit board 1 is measured as the dielectric breakdown voltage B (kV).

For example, as the electrodes, spherical electrodes having a tip diameter of 10 mm specified in JIS-C-2110-1 (2013) are used. The conditions of the electrodes when the dielectric breakdown voltage B is measured are the same as the conditions of the electrodes when the arc discharge voltage A is measured. The maximum voltage is 20 kV. As the unit of the dielectric breakdown voltage B, "kV/mm" obtained by dividing the voltage by the thickness of the ceramic circuit board 1 can be used. The unit of the arc discharge voltage and the unit of the dielectric breakdown voltage are standardized to either "kV" or" kV/mm".

The electrodes, the boosting rate, and the measurement environment when the dielectric breakdown voltage is measured are made the same as the electrodes, the boosting rate, and the measurement environment when the arc discharge voltage is measured, respectively. In a case where the size of the ceramic circuit board is small, a catalog value measured in accordance with IEC 672-2 may be used as the dielectric breakdown voltage of the ceramic circuit board 1. As a guide of the size, in a case where one side is less than 5 mm, it is preferable to use the catalog value. The catalog value is a typical numerical value shown by the manufacturer or the seller in a product catalog, specifications, or the like to indicate the performance or specifications of the product.

After the measurement of the arc discharge voltage, the dielectric breakdown voltage is measured. In the measurement of the dielectric breakdown voltage, the ceramic circuit board 1 is dielectrically broken down. Therefore, although the arc discharge voltage is measured three times, the dielectric breakdown voltage is measured only once. In the measurement of the dielectric breakdown voltage, in a case where a plurality of metal portions 3 are provided on the front face of the ceramic substrate 2, one of the electrodes is disposed on the metal portion 3 having the largest area. The other electrode is disposed on the metal portion 3 on the back face so as to face the one of the electrodes.

In the embodiment, in a case where the arc discharge voltage A (kV) and the dielectric breakdown voltage B (kV) of the ceramic circuit board 1 are measured, the ratio A/B is 0.10 or more.

An arc discharge is detected as a pulse current periodically generated in a case where an AC electric field having a certain frequency is applied to the ceramic circuit board 1. An arc discharge is likely to occur in a structure in which an electric field concentration can occur. Examples of the cause of the arc discharge include a void in the bonding layer 4 and a void in the ceramic substrate 2. The shape of the upper end portion of the side face of the metal portion 3 is also a cause of the arc discharge.

Inside the ceramic substrate 2, an arc discharge occurs in, for example, a void. When a voltage is applied to the ceramic circuit board 1, a partial voltage is applied to a void. In the ceramic substrate 2, the electric resistance value of the ceramic portion and that of the void portion are different from each other, and therefore, a voltage gradient is generated. In the void portion, the magnitude of the partial voltage varies depending on the size or shape of the void portion. When the partial voltage reaches the discharge voltage in the void, a partial discharge that causes an arc discharge occurs. A state in which a periodic pulse current of 10 kHz or more appears by the partial discharge is determined to be the occurrence of an arc discharge. A voltage at which the arc discharge starts occurring is detected and measured as the arc discharge voltage.

In the measurement of the dielectric breakdown voltage, a voltage when a large current is detected between the front face and the back face of the ceramic circuit board 1 is measured. When a dielectric breakdown occurs in the ceramic circuit board 1 and the structure of the ceramic circuit board 1 is broken, the electrodes are short-circuited, and a current much larger than before is detected. The voltage at this time is measured as the dielectric breakdown voltage B.

With the recent improved performance of semiconductor elements, the switching frequency has been increasing. Examples of power semiconductor elements can include Si elements, SiC elements, and GaN elements. The switching frequencies of these elements vary from several tens Hz to several hundreds kHz. Some of the recent semiconductor elements have a switching frequency of about 1 GHz. In a semiconductor element, a current is repeatedly turned on and off in accordance with the switching frequency. When a current is repeatedly turned on and off and an AC voltage is applied to the ceramic circuit board 1, an arc discharge may occur in the ceramic circuit board 1. As the arc discharge voltage of the ceramic circuit board 1 is lower, an arc discharge is more likely to occur in the ceramic circuit board 1 when a current is repeatedly turned on and off. When an arc discharge repeatedly occurs, the insulation of the ceramic circuit board 1 degrades. Therefore, long-term insulation of the ceramic circuit board 1 is unable to be maintained. That is, the insulation of the ceramic circuit board 1 degrades even though the voltage does not reach the dielectric breakdown voltage yet.

The switching frequency of Si-IGBT elements, which is one type of Si element, is typically about 100 Hz to 50 kHz. The switching frequency of SiC-MOS elements is about 8 kHz to 1 MHz. With the increase in the switching frequency, the output power and the power density have been increasing. For example, for a Si-IGBT element having a switching frequency of 25 kHz, the output power can be about 3.3 kW and the power density can be about 0.3 W/cm³. For a SiC-MOS element having a switching frequency of 160 kHz, the output power can be about 5 kW and the power density can be about 1.8 W/cm³. For GaAs-MESFETs (Metal Semiconductor FETs) and HEMTs (High Electron Mobility Transistors), the switching operating frequencies can be 1 GHz to 10 GHz. The increase in the switching frequency leads to an increase in the output voltage or the power density.

The ceramic circuit board 1 according to the embodiment exhibits excellent insulation even if a semiconductor element having a switching frequency of 8 kHz or more is mounted thereon. The ceramic circuit board 1 according to the embodiment exhibits excellent insulation even if a semiconductor element having an output power of 1 kW or more or a power density of 1 W/cm³ or more is mounted thereon. For a ceramic circuit board on which a semiconductor element with improved performance is mounted, the insulation of the ceramic circuit board is unable to be appropriately evaluated only with the dielectric breakdown voltage. According to the embodiment, since the ratio of the arc discharge voltage to the dielectric breakdown voltage is controlled, the ceramic circuit board 1 having insulation suitable for a semiconductor device is provided.

In a case where the arc discharge voltage A (kV) and the dielectric breakdown voltage B (kV) of the ceramic circuit board 1 according to the embodiment are measured, the ratio A/B is 0.10 or more. This indicates that the arc discharge voltage A is at least 0.10 times the dielectric breakdown voltage B. On the other hand, the ratio A/B being less than 0.10 indicates that the arc discharge voltage A is lower than 0.10 times the dielectric breakdown voltage B. In a case where the ratio A/B of the ceramic circuit board 1 is less than 0.10, insulation failure may occur in the ceramic circuit board 1 when a semiconductor element having a high switching frequency is mounted and used in spite of the high dielectric breakdown voltage. That is, the ceramic circuit board 1 having the ratio A/B less than 0.10 may lack in long-term reliability.

An arc discharge is detected as a pulse current periodically generated in a case where an AC electric field having a certain frequency is applied between the electrodes. The initial arc discharge phenomenon occurs, for example, in a void in the bonding layer 4 or a void in the ceramic substrate 2. As the arc discharge is repeated, a phenomenon called arc-causing deterioration occurs. As the arc-causing deterioration proceeds, a dielectric breakdown occurs. The arc discharge can be regarded as a sign of the dielectric breakdown. Therefore, when a voltage at which an arc discharge occurs is measured, the long-term reliability of the ceramic circuit board 1 can be checked. That is, as the ratio of the arc discharge voltage to the dielectric breakdown voltage is higher and an arc discharge is less likely to occur, arc-causing deterioration in the ceramic circuit board 1 is less likely to proceed. As a result, even in a case where a semiconductor device including the ceramic circuit board 1 is used for a long period, the occurrence of a dielectric breakdown in the ceramic circuit board 1 can be suppressed. As described above, the dielectric breakdown voltage of the ceramic substrate 2 is designed to be higher than the practical voltage. As the ratio A/B is larger, a voltage at which an arc discharge voltage occurs is closer to the dielectric breakdown voltage. That is, as the ratio A/B is larger, an arc discharge voltage is unlikely to occur at the practical voltage or is higher than the practical voltage. Therefore, as the ratio A/B is larger, arc-causing deterioration in the ceramic circuit board 1 can be more likely to be suppressed.

The measurement of the arc discharge voltage is a non-destructive test. In contrast, the dielectric strength is a destructive test. When the catalog value is used as the dielectric strength, the long-term reliability of the ceramic circuit board 1 can be checked by a non-destructive test.

In particular, as the switching frequency of a semiconductor element increases, the number of times of a pulse current periodically generated increases. As the output voltage and the power density increase, an arc discharge is more likely to occur inside the ceramic circuit board 1. Therefore, as the switching frequency, the output voltage, and the power density increase, the insulation inside the ceramic circuit board 1 is more likely to degrade by an arc discharge even in a state in which the ceramic circuit board 1 is not dielectrically broken down. As a result, the long-term reliability problem may arise.

The ratio A/B being 0.10 or more indicates that the ratio of the arc discharge voltage A to the dielectric breakdown voltage B is higher than that of ceramic circuit boards of the related art. Therefore, even in a case where the output voltage and the power density of the semiconductor element are large, an arc discharge is less likely to occur. Since the occurrence of an arc discharge is suppressed, the number of times an arc discharge occurs can be suppressed even in a case where the switching frequency of the mounted semiconductor element is high. In other words, suppressing the occurrence of an arc discharge leads to the improvement of the reliability of a semiconductor device that includes a semiconductor element having a high switching frequency.

The upper limit of the ratio A/B is 1.0. The ratio A/B = 1.0 indicates a state in which the arc discharge voltage and the dielectric breakdown voltage are substantially the same or a state in which an arc discharge is substantially not observed. The ratio A/B = 1.0 indicates that the ceramic circuit board 1 does not have a structure such that, even in a case where an AC electric field having a certain frequency is applied between the electrodes, a periodic pulse current is generated.

For example, in the ceramic circuit board 1, there is a case where a void is not substantially present in the ceramic substrate 2 or the bonding layer 4, and there is a case where a void is present but an arc discharge is unable to be detected (including a case where an arc discharge is below the detection limit). The ceramic circuit board 1 includes the metal portion 3, and when the arc discharge voltage is measured, the metal portion 3 electrically connected to the electrode substantially functions as an electrode for the ceramic substrate 2 and the bonding layer 4. Accordingly, the arc discharge voltage of the ceramic circuit board 1 can be measured more easily than in a case where the arc discharge voltage of only the ceramic substrate 2 is measured. Therefore, a state in which a void is present but an arc discharge is unable to be detected is actually less likely to occur. Making the ceramic substrate 2 and the bonding layer 4 without a void increases costs. From these viewpoints, the ratio A/B is preferably within a range of not less than 0.10 and not more than 0.50, and more preferably within a range of not less than 0.20 and not more than 0.45. In other words, according to the embodiment, even if a void is present in the ceramic substrate 2 or the bonding layer 4, a ceramic circuit board having long-term reliability can be provided.

The metal portion 3 is bonded to the ceramic substrate 2 with the bonding layer 4 interposed therebetween, and the total area ratio of voids (pores) in the bonding layer 4 is preferably within a range of not less than 0% and not more than 1%. As described above, a void in the bonding layer 4 causes an arc discharge to occur. Therefore, the number of voids in the bonding layer 4 is preferably smaller.

To measure the total area ratio of voids in the bonding layer 4, any cross section of the bonding layer 4 is observed with a scanning electron microscope (SEM). In the observation, a cross section in a direction perpendicular to the front face of the ceramic substrate 2 is used. The magnification of the SEM photograph is set at 1000-fold magnification. In the bonding layer 4, a region of 100 µm in width × the bonding layer thickness is observed. The total of the areas of the voids is calculated, and the total area is divided by the area of the observation region to calculate the total area ratio (%). In the cross-sectional SEM photograph, the contrast between the voids and the other portion is large. Since the voids look black compared with the other portion, the voids can be discriminated. In particular, in the bonding layer 4 including Ag, Cu, or Al as the main component, the contrast is large, and the difference in brightness between the voids and the other portion is large.

The metal portion 3 is preferably a metal plate, and as shown in FIG. 2, the upper end portion 5 of at least a part of the side face of the metal plate preferably has an R-shape. The upper end portion 5 is the uppermost portion of the side face of the metal plate. Preferably, the upper end portion 5 of the whole side face of the metal plate has the R-shape. In a case where a plurality of metal plates are provided on one of the faces of the ceramic substrate 2, two metal plates adjacent to each other have side faces facing each other. In this case, the upper end portion 5 of each of the side faces preferably has the R-shape. More preferably, the upper end portion 5 of the whole side face of each metal plate has the R-shape.

The R-shape is a shape such that a curved shape is provided between the side face and the upper face of the metal plate, and the radius of curvature of the curved shape is larger than 0. The R-shape is measured with a three-dimensional shape measuring device. At the upper end portion 5 (edge portion), an electric field concentration is likely to occur. In particular, if the metal portion 3 is a metal plate, an electric field concentration is likely to occur. Since the metal plate has a thickness of, for example, 0.2 mm or more, when the metal plate is given a circuit shape, the upper end portion of the side face of the metal plate is likely to have a right angle or an acute angle and to become sharp. For example, if the upper end portion of the side face of the metal plate is sharp, a discharge phenomenon is likely to occur between the upper end portions of the side faces of the metal plates facing each other. Therefore, the upper end portion of the side face of the metal plate is preferably given the R-shape. In contrast, since a sputtered film and a metallized layer are thin films, a discharge phenomenon is less likely to occur. Therefore, in a ceramic circuit board in which a metal plate having a thickness of 0.2 mm or more is bonded, the upper end portion of the side face of the metal plate is preferably given the R-shape.

Examples in which the upper end portion 5 does not have the R-shape include a metal plate in which the angle of the upper end portion 5 (the angle between the side face and the upper face) is 90° or less. If the angle of the upper end portion 5 is 90° or less, the upper end portion 5 of the metal plate has a sharp shape. In a case where the upper end portion 5 has a sharp shape, a discharge phenomenon is likely to occur between the upper end portions 5 of the metal plates facing each other. In particular, in a case where the distance between the upper end portions 5 of the metal plates adjacent to each other is 3 mm or less, there is a possibility that a discharge phenomenon occurs and an electric field concentration occurs. In other words, in a case where a part is present between the metal plates adjacent to each other, in which the distance between the upper end portions 5 is 3 mm or less, the upper end portions 5 preferably have the R-shape. Further, when the side face of the metal plate is given an inclined shape, the upper end portion 5 can be given an angle exceeding 90°. When the angle of the upper end portion 5 exceeds 90° and the upper end portion 5 is given the R-shape, the occurrence of an electric field concentration can be further suppressed.

In a case where a metal plate is used as the metal portion 3, the metal portion 3 can be made thicker than in a case where a metallized layer or a conductive thin film is used as the metal portion 3. Therefore, in order to improve the current carrying capacity of the metal portion 3, it is preferable to use a metal plate as the metal portion 3. Further, when the upper end portion 5 of the side face of the metal plate is given the R-shape, the occurrence of an arc discharge can be suppressed.

The upper limit of the radius of curvature of the R-shape of the upper end portion 5 is not specifically limited, but is preferably 300 µm or less. If the radius of curvature exceeds 300 µm, the area of the flat portion on the upper face of the metal portion 3 becomes smaller. A region in which a semiconductor element is mounted is preferably flat. If the radius of curvature exceeds 300 µm, the area of a region that can be used to mount a semiconductor element may become smaller. Therefore, the radius of curvature of the R-shape of the upper end portion 5 is preferably more than 0 µm and not more than 300 µm, and more preferably within a range of not less than 5 µm and not more than 200 µm.

The bonded area of the metal portion 3 bonded to one of the faces of the ceramic substrate 2 is, for example, at least 40% of the area of the one of the faces of the ceramic substrate 2. In a case where a plurality of metal portions 3 are provided on one of the faces of the ceramic substrate 2, the total of the bonded areas of the plurality of metal portions 3 is at least 40% of the area of the one of the faces. In a case where a plurality of metal portions 3 are provided on each of the front face and the back face of the ceramic substrate 2, the ratio of the bonded areas may be 40% or more on each of the front face and the back face.

As described above, an electric field concentration is likely to occur at the upper end portion 5 of the metal portion 3. In a case where a plurality of metal portions 3 are provided, the area of the upper end portions 5 is larger than in a case where only one metal portion 3 is provided. When the upper end portions 5 of the metal portions 3 are large, this may cause an arc discharge to easily occur. Further, if the upper end portions 5 of the metal portions 3 face each other, an arc discharge may be likely to occur between the upper end portions 5. In particular, in a case where a plurality of metal portions 3 are provided and the ratio of the bonded areas is 40% or more, the area of the upper end portions 5 facing each other is larger, and the distance between the upper end portions 5 becomes closer. As a result, an arc discharge is likely to occur between the upper end portions 5.

In the ceramic circuit board 1 according to the embodiment, the ratio A/B is controlled to be 0.10 or more. In other words, according to the embodiment, even in a case where the bonded area of the metal portion 3 increases, the ratio A/B is controlled to be 0.10 or more and an arc discharge is suppressed. For example, according to the embodiment, even if a plurality of metal portions 3 are provided on one of the front face or the back face of the ceramic substrate 2 and the ratio of the bonded areas on the one of the front face or the back face is 40% or more, the ratio A/B is controlled to be 0.10 or more and an arc discharge on the one of the front face or the back face is suppressed. Even if a plurality of metal portions 3 are provided on each of the front face and the back face of the ceramic substrate 2 and the ratio of the bonded areas on each of the front face and the back face is 40% or more, the ratio A/B is controlled to be 0.10 or more and an arc discharge on both faces is suppressed.

To control the ratio A/B, control of voids in the ceramic substrate 2 is also effective. FIG. 3 is a schematic diagram showing a cross section of the ceramic substrate. In FIG. 3, reference numeral 6 denotes a cross section of the ceramic substrate, reference numeral 7 denotes a void having an area of 1µm² or more, and reference numeral 8 denotes a void having an area of less than 1µm². The void 7 having an area of 1µm² or more may be referred to as a large void (second void). The void 8 having an area of less than 1µm² may be referred to as a small void (first void).

In any cross section of the ceramic substrate 2, a region of 90 µm × 120 µm is preferably present in which the number of small voids having an area of less than 1 µm² is not less than 30 and not more than 500 and the number of large voids having an area of 1 µm² or more is not less than 0 and not more than 30. The large voids 7 are likely to cause an arc discharge to occur. Therefore, in the region of 90 µm × 120 µm, the number of large voids 7 is preferably within a range of not less than 0 and not more than 30, and more preferably within a range of not less than 0 and not more than 20. Although the small voids 8 are less likely to cause an arc discharge, if the number of small voids 8 is too large, the small voids 8 may affect the arc discharge voltage. Reducing the number of small voids 8 to zero is costly. Therefore, the number of small voids 8 is preferably within a range of not less than 30 and not more than 500, and more preferably within a range of not less than 40 and not more than 400.

A measurement method for voids will be described. First, a cross section in a direction perpendicular to the front face of the ceramic substrate 2 is prepared. A polished face having a surface roughness Ra of 1 µm or less is used as the cross section. The cross section is observed with a SEM, and a 1000-fold enlarged photograph is taken. As the SEM, JCM-7000 or JSM-7200F from JEOL or a device having performance equivalent to or higher than that of JCM-7000 or JSM-7200F is used. An area of 180 µm × 430 µm in the cross section is observed with the SEM. In the area of 180 µm × 430 µm, three regions of 90 µm × 120 µm that do not overlap each other are set. Voids present in each region are observed. Among the three regions, a region of 90 µm × 120 µm in which the largest number of voids are observed is selected.

In the region of 90 µm × 120 µm in which the largest number of voids are observed among the three regions, the number of large voids 7 and the number of small voids 8 need to be within the above-described respective ranges, and in the regions not selected, the number of large voids 7 and the number of small voids 8 may fall below the above-described respective ranges. In other words, according to the embodiment, even in the region of 90 µm × 120 µm in which the number of voids is largest in a cross section of the ceramic substrate 2, the number of large voids 7 is controlled to be not less than 0 and not more than 20, and the number of small voids 8 is controlled to be not less than 30 and not more than 500.

In a case where an area of 180 µm × 430 µm is unable to be observed in one field of view, the area of 180 µm × 430 µm may be observed a plurality of times from area to area. In this case, the minimum size of the observed area is set to 90 µm × 120 µm. The orientation of the sample with respect to the observed area of 180 µm × 430 µm and the region of 90 µm × 120 µm is any orientation. The orientation of the observed area of 180 µm × 430 µm and the orientation of the region of 90 µm × 120 µm may be adjusted so that the largest number of voids can be observed in any cross section.

The total area ratio of the small voids 8 having an area of less than 1 µm² and present in the region of 90 µm × 120 µm is preferably within a range of not less than 0.01% and not more than 0.8%. The total area ratio of the large voids 7 having an area of 1 µm² or more and present in the region of 90 µm × 120 µm is preferably within a range of not less than 0% and not more than 0.6%. Controlling the total area ratio of the small voids 8 and the total area ratio of the large voids 7 is effective in suppressing the occurrence of an arc discharge.

In the region of 90 µm × 120 µm, the maximum diameter of the voids is preferably 15 µm or less. After selection of the region of 90 µm × 120 µm including the largest number of voids, the long diameter of each void present in the region is measured. The "long diameter" is the distance between two points present on the outer edge of the void and farthest from each other. The largest value of the long diameters of the plurality of voids is determined to be "maximum diameter". When the maximum diameter of the voids is controlled to be 15 µm or less, degradation of the insulation of the ceramic circuit board 1 due to the large voids 7 can be suppressed.

In the region of 90 µm × 120 µm, the number of sets of large voids 7 distant from each other by 5 µm or less is preferably not less than 0 and not more than 3. When the distance between one large void 7 and another large void 7 is 5 µm or less, these large voids 7 are counted as one set. In a case where two large voids 7 are present within a range of 5 µm from one reference large void 7, the reference large void 7 and the two large voids 7 are counted as two sets. In a case where three or more large voids 7 are present within a range of 5 µm from one large void 7, these large voids 7 are counted as three or more sets. For example, in a case where three large voids 7 are distributed in a triangular shape at a distance of 5 µm or less from each other, these large voids 7 are counted as three sets.

The distance is measured using an enlarged photograph of the observed cross section. A range of 5 µm centered around each observed large void 7 is set, and in a case where other large voids 7 are present within the range, the number of the sets is counted. When a range of 5 µm centered around another large void 7 is set thereafter, the sets once counted are not counted again.

If the large voids 7 are close to each other, the large voids 7 may function similarly to a larger void. For example, if the number of sets of large voids 7 distant from each other by 5 µm or less exceeds three, the arc discharge voltage and the dielectric breakdown voltage may decrease, and the insulation of the ceramic circuit board 1 may degrade. Therefore, the number of sets of large voids 7 distant from each other by 5 µm or less is preferably within a range of not less than 0 and not more than 3, and more preferably within a range of not less than 0 and not more than 1. Even if the small void 8 is present near the large void 7, the set of the large void 7 and the small void 8 is not counted. This is because even if the large void 7 and the small void 8 are close to each other, the adverse effect on the insulation is small. Here, only the sets of large voids 7 distant from each other by 5 µm or less are counted.

As long as voids in the ceramic substrate 2 are controlled, the ratio between the arc discharge voltage and the dielectric breakdown voltage of the ceramic substrate 2 itself can be 0.3 or more. To make the ratio A/B of the ceramic circuit board 1 be 0.10 or more, it is also effective to use the ceramic substrate 2 for which the ratio of the arc discharge voltage to the dielectric breakdown voltage is 0.3 or more. In particular, it is preferable to use the ceramic substrate 2 having a thickness of not less than 0.2 mm and not more than 3 mm and a ratio of the arc discharge voltage to the dielectric breakdown voltage of 0.3 or more. The measurement methods for the arc discharge voltage and the dielectric breakdown voltage of the ceramic substrate 2 are the same as the measurement methods for the arc discharge voltage and the dielectric breakdown voltage of the ceramic circuit board 1. As the value of the dielectric breakdown voltage of the ceramic substrate 2, a catalog value measured in accordance with JIS-C-2141 (1992) may be used.

In the observation of voids, the SEM photograph is analyzed using image analysis software. As the image analysis software, ImageJ or software equivalent to or surpassing ImageJ is used. In the SEM photograph of the cross section, there is a contrast between voids and the other portion. For example, the color of the voids look more blackened and darker than the color of the portion other than the voids. When this contrast is used to binarize the SEM photograph, the voids and the other portion can be discriminated from each other. Voids of 0.01 µm² or more are counted as small voids. This is because it is difficult to discriminate a void having an area of less than 0.01 µm² in the 1000-fold enlarged photograph.

As the threshold value for the binarization, a value obtained by "mode method" or "discriminant analysis binarization method" is used. In a case where the image analysis software has the function of the discriminant analysis binarization method, the discriminant analysis binarization method of the image analysis software is used. In the discriminant analysis binarization method, the threshold value is determined unambiguously by the analysis software. Therefore, voids can be easily discriminated. For example, a region looking white around a void in the SEM photograph is the boundary between the void and the silicon nitride sintered body. Therefore, the region looking white around a void is not to be counted as a void. The silicon nitride sintered body is gray in the SEM photograph. When the threshold value obtained by the "mode method" or the "discriminant analysis binarization method" is used, voids can be shown in black, and a white region around a void and the silicon nitride sintered body can be shown in white. When the binarized image is used, voids and the other region present in the SEM photograph can be discriminated from each other.

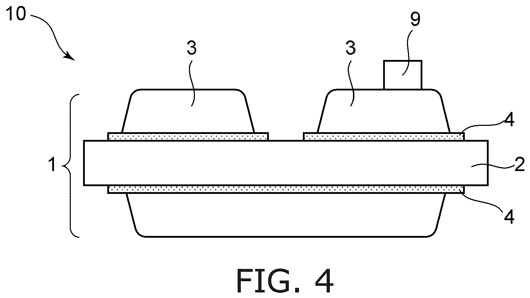

The ceramic circuit board 1 according to the embodiment can be used in a semiconductor device. When a semiconductor element is mounted on the ceramic circuit board 1, a semiconductor device is obtained. FIG. 4 is a side view of an example of a semiconductor device according to the embodiment. In FIG. 4, reference numeral 1 denotes a ceramic circuit board, reference numeral 9 denotes a semiconductor element, and reference numeral 10 denotes a semiconductor device.

As shown in FIG. 4, when the semiconductor element 9 is mounted on at least one of the metal portions 3 of the ceramic circuit board 1, the semiconductor device 10 can be made. In the example shown in FIG. 4, one semiconductor element 9 is mounted on one metal portion 3. A plurality of semiconductor elements 9 may be mounted on a plurality of metal portions 3, respectively. A plurality of semiconductor elements 9 may be mounted on one metal portion 3. In addition to the semiconductor element 9, a lead frame, wire bonding, etc. may be bonded to the metal portion 3. When the arc discharge voltage of the ceramic circuit board 1 is improved, the long-term reliability of the insulation of the semiconductor device 10 can be maintained even in a case where the semiconductor element 9 having a high switching frequency is mounted.

A manufacturing method for the ceramic circuit board 1 according to the embodiment will now be described. The manufacturing method is not specifically limited as long as the ceramic circuit board 1 according to the embodiment has the above-described configuration. Here, an example method for obtaining the ceramic circuit board 1 with a high yield will be described. For example, a manufacturing method for a ceramic circuit board in which a metal plate is bonded using an active metal brazing filler will be described below.

First, the ceramic substrate 2 is prepared. The ceramic substrate 2 may be one type selected from among a silicon nitride substrate, an aluminum nitride substrate, an aluminum oxide substrate, and a zirconium oxide substrate. As described above, it is preferable to use the ceramic substrate 2 for which voids are controlled. It is also preferable to use the ceramic substrate 2 for which the ratio of the arc discharge voltage to the dielectric breakdown voltage is 0.3 or more.

Next, a metal plate is prepared. The metal plate is preferably a copper plate, a copper alloy plate, an aluminum plate, or an aluminum plate. In a case where a plurality of metal plates are used, two or more types selected from among copper plates, copper alloy plates, aluminum plates, and aluminum plates may be used.

Next, an active metal brazing filler is prepared. In a case where the metal plate is a copper plate (including a copper alloy plate), an active metal brazing filler including Ag or Cu as the main component is used. In a case where the metal plate is an aluminum plate (including an aluminum alloy plate), an active metal brazing filler including Al as the main component is used. The preferable composition of the active metal brazing filler is as described above.

The active metal brazing filler is formed into a paste and applied to the front face of the ceramic substrate 2, and the metal plate is disposed thereon. In a case where the metal plates are bonded to both faces of the ceramic substrate 2, the active metal brazing filler paste is also applied to the back face, and the metal plate is disposed thereon. By the above-described processes, a stacked body having a stacked structure constituted by the metal plate, the active metal brazing filler layer, and the ceramic substrate 2 can be made.

Next, a process of heating and bonding the stacked body is performed. The heating temperature is preferably within a range of not less than 600°C and not more than 950°C. In the heating and bonding process, the temperature of the stacked body is increased to the heating temperature, and thereafter, the stacked body is held at the heating temperature for a certain period. Thereafter, the stacked body is cooled to normal temperature. In the heating and bonding process, for example, a batch furnace, a continuous furnace, or a hot press can be used. By the heating and bonding process, the active metal brazing filler melts and thereafter solidifies to form the bonding layer 4.

To decrease the total area ratio of voids in the bonding layer 4 to 1% or less, it is effective to extend the bonding time. The bonding time can be extended by, for example, a method of increasing the time for holding at the heating temperature or a method of decreasing the cooling rate after the holding at the heating temperature. The time for holding at the heating temperature is preferably 30 minutes or more, and more preferably within a range of not less than 1 hour and not more than 5 hours. The cooling rate after the holding at the heating temperature is preferably 100°C/hour or less, and more preferably 50°C/hour or less.

Extending the bonding time allows the active metal brazing filler to sufficiently melt to thereby fill the voids in the bonding layer 4. Decreasing the cooling rate also produces the effect of filling the voids before the bonding layer 4 solidifies. A method of increasing the vacuum of the bonding atmosphere is also effective. Increasing the vacuum of the bonding atmosphere can suppress oxidation of the active metal brazing filler. This can suppress generation of voids. The vacuum is preferably 10⁻² Pa or less, and more preferably 10⁻³ Pa or less. The method of extending the bonding time, the method of decreasing the cooling rate, and the method of increasing the vacuum of the bonding atmosphere may be used individually or in combination. By the heating and bonding process, a bonded body can be obtained.

Next, an etching process is performed on the obtained bonded body to give the metal plate a circuit shape. The etching process may be performed in order to control the side face shape of the metal plate or the size of the bonding layer protruding portion.

The etching process is preferably performed so as to give the upper end portion 5 of the side face of the metal plate the R-shape. In order to give the upper end portion 5 the R-shape, it is effective to etch the upper end portion 5. For example, the upper end portion 5 can be given the R-shape by masking the portion other than the upper end portion 5 and etching only the upper end portion 5. Alternatively, instead of the etching process, a metal plate in which the upper end portion 5 is given in advance the R-shape may be bonded to the ceramic substrate 2.

By the above-described processes, the ceramic circuit board 1 according to the embodiment can be made. When the semiconductor element 9 is mounted on the ceramic circuit board 1, the semiconductor device 10 can be made.

### (Examples 1 to 5 and Comparative Examples 1 to 4)

As ceramic substrates, silicon nitride substrates and aluminum nitride substrates were prepared. The thermal conductivity of the silicon nitride substrates is 90 W/m·K or more, and the three-point bending strength thereof is 600 MPa or more. The thermal conductivity of the aluminum nitride substrates is 180 W/m·K or more, and the three-point bending strength thereof is 400 MPa or more.

The thickness, arc discharge voltage/dielectric strength voltage, and void distribution of each ceramic substrate are as shown in Table 1 and Table 2. The arc discharge voltage, the dielectric strength voltage, and the void distribution were measured in accordance with the measurement methods described above. For the void distribution, three regions of 90 µm × 120 µm in an area of 180 µm × 430 µm were observed, and the distribution in a region in which the number of voids is largest is shown in Table 2.

**[Table 1]**

| | Ceramic substrate | Substrate thickness (mm) | Dielectric breakdown voltage (kV) | Arc discharge voltage/ dielectric breakdown voltage |
|---|---|---|---|---|
| Example 1 | Silicon nitride | 0.32 | 9.6 | 0.9 |
| Example 2 | Silicon nitride | 0.32 | 9.5 | 0.8 |
| Example 3 | Silicon nitride | 0.25 | 9.1 | 0.7 |
| Example 4 | Silicon nitride | 0.25 | 8.9 | 0.6 |
| Example 5 | Aluminum nitride | 0.635 | 8.9 | 0.5 |
| Comparative example 1 | Silicon nitride | 0.32 | 9.4 | 0.2 |
| Comparative example 2 | Silicon nitride | 0.32 | 9.0 | 0.2 |
| Comparative example 3 | Aluminum nitride | 0.635 | 8.7 | 0.2 |
| Comparative example 4 | Silicon nitride | 0.32 | 8.8 | 0.3 |

**[Table 2]**

| | Voids of less than 1µm² | | Voids of 1µm² or more | | | Void maximum diameter (µm) |
|---|---|---|---|---|---|---|
| | Number | Area ratio (%) | Number | Area ratio (%) | Number of sets for which distance is 5µm or less | |
| Example 1 | 46 | 0.04 | 3 | 0.2 | 1 | 5 |
| Example 2 | 102 | 0.05 | 9 | 0.2 | 2 | 10 |
| Example 3 | 167 | 0.4 | 19 | 0.5 | 3 | 11 |
| Example 4 | 181 | 0.6 | 22 | 0.5 | 3 | 15 |
| Example 5 | 302 | 0.8 | 14 | 0.2 | 3 | 18 |
| Comparative example 1 | 711 | 1.3 | 60 | 0.9 | 9 | 21 |
| Comparative example 2 | 823 | 1.8 | 66 | 1.2 | 12 | 24 |
| Comparative example 3 | 679 | 1.7 | 62 | 1.1 | 9 | 19 |
| Comparative example 4 | 566 | 1.0 | 25 | 0.7 | 2 | 19 |

As can be seen from Table 2, in Examples, the distribution of voids in the ceramic substrate is controlled within the preferable range. In contrast, in Comparative Examples, the distribution of voids in the ceramic substrate was out of the preferable range. Further, in all Examples, the ratio of arc discharge voltage/dielectric breakdown voltage of the ceramic substrate was 0.3 or more. In contrast, in some Comparative Examples, the ratio of arc discharge voltage/dielectric breakdown voltage of the ceramic substrate was less than 0.3.

Next, a metal plate was bonded to the ceramic substrate using an active metal brazing filler. As the metal plate, a copper plate was used. As the active metal brazing filler, an Ag-Cu-Sn-TiH₂ brazing filler or a Cu-Sn-TiH₂ brazing filler was used. The heating temperature was set within a range of not less than 750°C and not more than 850°C. The heating and bonding process was performed in a vacuum of 10⁻³ Pa or less, and the bonding time was set to 1 hour or more. This active metal bonding method was used to bond metal plates to both faces of the ceramic substrate.

The obtained bonded body was subjected to the etching process to give the metal plate on the front face a circuit shape. By this process, a plurality of metal portions were formed on the front face of the ceramic substrate. The metal plate on the back face was not given a circuit shape and was used as a heat sink. Further, the side face of each of the metal plates on the front face and the back face was given an inclined shape to provide a bonding layer protruding portion to the bonding layer 4.

By the above-described processes, ceramic circuit boards according to Examples and Comparative Examples were made. The bonded area of the metal plate in each ceramic circuit board, the total area ratio of voids in the bonding layer, and the R-shape of the upper end portion of the metal plate are shown in Table 3. The measurement methods for the bonded area of the metal plate, the total ratio of voids, and the R-shape (radius of curvature) of the upper end portion of the metal plate are as described above. In Table 3, the copper plate bonded to the front face of the ceramic substrate is referred to as "front copper plate", and the copper plate bonded to the back face of the ceramic substrate is referred to as "back copper plate".

**[Table 3]**

| | Front copper plate | | Back copper plate | | Total area ratio of voids in bonding layer (%) | Radius of curvature of R-shape (µm) |
|---|---|---|---|---|---|---|
| | Thickness (mm) | Bonding area (%) | Thickness (mm) | Bonding area (%) | | |
| Example 1 | 0.6 | 40 | 0.6 | 80 | <1 | 10 |
| Example 2 | 0.8 | 45 | 0.8 | 80 | <1 | 30 |
| Example 3 | 0.8 | 50 | 0.7 | 80 | <1 | 60 |
| Example 4 | 1.0 | 52 | 1.0 | 80 | <1 | 100 |
| Example 5 | 0.3 | 40 | 0.3 | 80 | <1 | 160 |
| Comparative example 1 | 0.6 | 40 | 0.6 | 80 | 3 | None |
| Comparative example 2 | 0.6 | 40 | 0.6 | 80 | 3 | None |
| Comparative example 3 | 0.3 | 40 | 0.3 | 80 | 3 | None |
| Comparative example 4 | 0.6 | 40 | 0.6 | 80 | 4 | None |

In each of the ceramic circuit boards according to Examples and Comparative Examples, the front copper plate is given a plurality of pattern shapes (metal portions). In Examples, the total area ratio of voids in the bonding layer is 1% or less (including 0%), and the upper end portion of the metal plate is given the R-shape. In Comparative Examples, the total area ratio of voids in the bonding layer is 3% or more, and the upper end portion of the metal plate is not given the R-shape.

Next, the arc discharge voltage A and the dielectric breakdown voltage B of each of the ceramic circuit boards according to Examples and Comparative Examples were measured. The measurement methods for the respective voltages are as described above. The results are shown in Table 4.

**[Table 4]**

| | Ceramic circuit board | | |
|---|---|---|---|
| | Arc discharge voltage A (kV) | Dielectric breakdown voltage B (kV) | A/B |
| Example 1 | 3.8 | 9.4 | 0.4 |
| Example 2 | 2.8 | 9.2 | 0.3 |
| Example 3 | 2.6 | 8.8 | 0.3 |
| Example 4 | 2.6 | 8.5 | 0.3 |
| Example 5 | 1.7 | 8.6 | 0.2 |
| Comparative example 1 | 0.8 | 9.0 | <0.1 |
| Comparative example 2 | 0.7 | 8.7 | <0.1 |
| Comparative example 3 | 0.7 | 8.4 | <0.1 |
| Comparative example 4 | 0.8 | 9.0 | <0.1 |

As can be seen from Table 4, in Examples, the ratio of arc discharge voltage A/dielectric breakdown voltage B was 0.2 or more. Therefore, it is found that the ratio of arc discharge voltage/dielectric breakdown voltage of the ceramic substrate, the control of voids, the total area ratio of voids in the bonding layer, and the R shape of the upper end portion of the metal plate are effective in controlling the ratio of arc discharge voltage A/dielectric breakdown voltage B of the ceramic circuit board. In contrast, in Comparative Examples, although the dielectric breakdown voltages of the ceramic circuit boards were equivalent to those in Examples, the arc discharge voltages decreased. As a result, the ratio of the arc discharge voltage to the dielectric breakdown voltage fell below 0.1. Therefore, it is found that the ceramic circuit boards according to Examples excel in long-term reliability.

Embodiments of the invention include the following features.

### (Feature 1)

A ceramic circuit board including:
a ceramic substrate; and
a metal portion bonded to the ceramic substrate,
in a case where an AC voltage of 50 Hz or 60 Hz is applied between a front face and a back face of the ceramic circuit board at a boosting rate of 200 V/s to measure an arc discharge voltage A (kV) when an arc discharge is detected and to measure a dielectric breakdown voltage B (kV) between the front face and the back face in accordance with IEC 672-2, a ratio A/B being 0.10 or more.

### (Feature 2)

The ceramic circuit board according to Feature 1, in which the ratio A/B is within a range of not less than 0.10 and not more than 0.50.

### (Feature 3)

The ceramic circuit board according to Feature 1 or 2, in which
the metal portion is bonded to the ceramic substrate with a bonding layer interposed therebetween, and
a total area ratio of voids in any cross section of the bonding layer is within a range of not less than 0% and not more than 1%.

### (Feature 4)

The ceramic circuit board according to any one of Features 1 to 3, in which
the metal portion is a metal plate having a thickness of 0.2 mm or more, and
an upper end portion of at least a part of a side face of the metal plate has an R-shape.

### (Feature 5)

The ceramic circuit board according to any one of Features 1 to 4, in which the metal portion is a copper plate having a thickness of 0.6 mm or more.

### (Feature 6)

The ceramic circuit board according to any one of Features 1 to 5, in which the ceramic substrate has a thickness within a range of not less than 0.2 mm and not more than 3 mm.

### (Feature 7)

The ceramic circuit board according to Feature 6, in which any cross section of the ceramic substrate includes a region of 90 µm × 120 µm in which a number of first voids having an area of less than 1 µm² is within a range of not less than 30 and not more than 500 and a number of second voids having an area of 1 µm² or more is within a range of not less than 0 and not more than 30.

### (Feature 8)

The ceramic circuit board according to Feature 7, in which in the region of 90 µm × 120 µm, a total area ratio of the first voids is within a range of not less than 0.01% and not more than 0.8%.

### (Feature 9)

The ceramic circuit board according to Feature 8, in which in the region of 90 µm × 120 µm, a total area ratio of the second voids is within a range of not less than 0% and not more than 0.6%.

### (Feature 10)

The ceramic circuit board according to Feature 9, in which in the region of 90 µm × 120 µm, a maximum diameter of the voids is 15 µm or less.

### (Feature 11)

The ceramic circuit board according to Feature 10, in which in the region of 90 µm × 120 µm, of the second voids, a number of sets of second voids distant from each other by 5 µm or less is 3 or less.

### (Feature 12)

The ceramic circuit board according to any one of Features 7 to 11, in which the ceramic substrate is a silicon nitride substrate having a thickness of not less than 0.2 mm and not more than 3 mm.

### (Feature 13)

A semiconductor device including:
the ceramic circuit board according to any one of Features 1 to 12; and
a semiconductor element mounted on the ceramic circuit board.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Moreover, above-mentioned embodiments can be combined mutually and can be carried out.

### [Reference Numeral List]

1 ceramic circuit board
2 ceramic substrate
3 metal portion (metal plate)
4 bonding layer
5 upper end portion of metal plate
6 cross section of ceramic substrate
7 void having area of 1µm² or more
8 void having area of less than 1µm²
9 semiconductor element
10 semiconductor device

## Claims

1. A ceramic circuit board comprising:
a ceramic substrate; and
a metal portion bonded to the ceramic substrate,
in a case where an AC voltage of 50 Hz or 60 Hz is applied between a front face and a back face of the ceramic circuit board at a boosting rate of 200 V/s to measure an arc discharge voltage A (kV) when an arc discharge is detected and to measure a dielectric breakdown voltage B (kV) between the front face and the back face in accordance with IEC 672-2, a ratio A/B being 0.10 or more.

2. The ceramic circuit board according to claim 1, wherein the ratio A/B is within a range of not less than 0.10 and not more than 0.50.

3. The ceramic circuit board according to claim 1 or 2, wherein
the metal portion is bonded to the ceramic substrate with a bonding layer interposed therebetween, and
a total area ratio of voids in any cross section of the bonding layer is within a range of not less than 0% and not more than 1%.

4. The ceramic circuit board according to any one of claims 1 to 3, wherein
the metal portion is a metal plate having a thickness of 0.2 mm or more, and
an upper end portion of at least a part of a side face of the metal plate has an R-shape.

5. The ceramic circuit board according to any one of claims 1 to 4, wherein the metal portion is a copper plate having a thickness of 0.6 mm or more.

6. The ceramic circuit board according to any one of claims 1 to 5, wherein the ceramic substrate has a thickness within a range of not less than 0.2 mm and not more than 3 mm.

7. The ceramic circuit board according to claim 6, wherein any cross section of the ceramic substrate includes a region of 90 µm × 120 µm in which a number of first voids having an area of less than 1 µm² is within a range of not less than 30 and not more than 500 and a number of second voids having an area of 1 µm² or more is within a range of not less than 0 and not more than 30.

8. The ceramic circuit board according to claim 7, wherein in the region of 90 µm × 120 µm, a total area ratio of the first voids is within a range of not less than 0.01% and not more than 0.8%.

9. The ceramic circuit board according to claim 8, wherein in the region of 90 µm × 120 µm, a total area ratio of the second voids is within a range of not less than 0% and not more than 0.6%.

10. The ceramic circuit board according to claim 9, wherein in the region of 90 µm × 120 µm, a maximum diameter of the voids is 15 µm or less.

11. The ceramic circuit board according to claim 10, wherein in the region of 90 µm × 120 µm, of the second voids, a number of sets of second voids distant from each other by 5 µm or less is 3 or less.

12. The ceramic circuit board according to any one of claims 7 to 11, wherein the ceramic substrate is a silicon nitride substrate having a thickness of not less than 0.2 mm and not more than 3 mm.

13. A semiconductor device comprising:
the ceramic circuit board according to any one of claims 1 to 12; and
a semiconductor element mounted on the ceramic circuit board.
